# EUROPEAN PATENT APPLICATION

(11) **EP 2 521 163 A1**
(43) Date of publication of application: **07.11.2012**
(21) Application number: 10840919.4
(22) Date of filing: 21.12.2010
(51) Int. Cl.: H01L 21/027, G03F 7/20

(54) **LIQUID IMMERSION MEMBER, METHOD FOR MANUFACTURING LIQUID IMMERSION MEMBER, EXPOSURE APPARATUS, AND DEVICE MANUFACTURING METHOD**

(30) Priority: 28.12.2009 US 282182 P
(71) Applicant: Nikon Corporation, Tokyo 100-8331 (JP)
(72) Inventor: TAKI Yusuke, Tokyo 100-8331 (JP)
(74) Representative: Viering, Jentschura & Partner
(86) International application number: PCT/JP2010/073024
(87) International publication number: WO 2011/081062

(57) **Abstract**

A liquid immersion member (6) holds liquid (LQ) between the liquid immersion member and an object such that an optical path (K) of exposure light (EL) applied to the object is filled with the liquid (LQ), thereby forming a liquid immersion space (LS). In the liquid immersion member (6), an amorphous carbon film is formed on at least a part of a region coming into contact with the liquid (LQ).

## Description

### Technical Field

The present invention relates to a liquid immersion member, a method for manufacturing the liquid immersion member, an exposure apparatus, and a device manufacturing method.

### Background Art

In exposure apparatuses used in a photolithography process, for example, as disclosed in the following Patent Documents, a liquid immersion exposure apparatus in which a substrate is exposed to exposure light via liquid.

### Citation List

### Patent Document

[Patent Document 1] U.S. Unexamined Patent Application Publication No. 2008/266533
[Patent Document 2] U.S. Unexamined Patent Application Publication No. 2005/018155

### Summary of Invention

### Technical Problem

In the liquid immersion exposure apparatus, there are cases where components included in a resist or an overcoat on a substrate surface may elute to liquid (for example, pure water) in a state where a liquid immersion region is formed on an object such as a substrate. For this reason, there is possibility that the resist or overcoat component which has eluted to the liquid (pure water) is reprecipitated on a member surface forming a liquid immersion region, and the precipitate is peeled therefrom by liquid current (water current) and is adhered to the substrate. If the substrate to which the precipitate is adhered is exposed, exposure defects occur such as defects occurring in a pattern formed on the substrate, and thus poor devices may be generated. In addition, there are cases where foreign substances mixed with the liquid may be adhered to the member forming the liquid immersion region and thus the substrate may be exposed in a state where the adhered foreign substances are mixed with the liquid again.

For this reason, although it is necessary to remove the precipitate on the surface by periodically cleaning the member forming the liquid immersion region, there is possibility that productivity may be reduced if the cleaning repetition and period increase.

According to aspects of the present invention, an object is to provide a liquid immersion member, a method for manufacturing the liquid immersion member, and an exposure apparatus capable of suppressing occurrences of exposure defects and reduction in productivity. In addition, another object is to provide a device manufacturing method capable of suppressing generation of poor devices and reduction in productivity.

### Solution to Problem

According to a first aspect of the present invention, there is provided a liquid immersion member which holds liquid between the liquid immersion member and an object such that an optical path of exposure light applied to the object is filled with the liquid, thereby forming a liquid immersion space, including an amorphous carbon film that is formed on at least a part of a region coming into contact with the liquid.

According to a second aspect of the present invention, there is provided a method for manufacturing a liquid immersion member which holds liquid between the liquid immersion member and an object such that an optical path of exposure light applied to the object is filled with the liquid, thereby forming a liquid immersion space, including forming an amorphous carbon film on at least a part of a region coming into contact with the liquid using a CVD method (Chemical Vapor Deposition method) or a PVD method (Physical Vapor Deposition method).

According to a third aspect of the present invention, there is provided an exposure apparatus which exposes a substrate to exposure light via liquid, including the liquid immersion member according to the first aspect.

According to a fourth aspect of the present invention, there is provided a device manufacturing method including a step of exposing a substrate using the exposure apparatus according to the aspect; and a step of developing the exposed substrate.

### Advantageous Effects of Invention

According to the aspects related to the present invention, it is possible to provide a liquid immersion member, a method for manufacturing the liquid immersion member, and an exposure apparatus capable of suppressing occurrences of exposure defects and reduction in productivity. In addition, according to the aspects related to the present invention, it is possible to provide a device manufacturing method capable of suppressing generation of poor devices and reduction in productivity.

### Brief Description of Drawings

FIG. 1 is a schematic configuration diagram illustrating an exposure apparatus.
FIG. 2 is a side cross-sectional view illustrating the vicinity of the liquid immersion member.
FIG. 3A is a schematic configuration diagram illustrating an example of the FCVA film forming apparatus.
FIG. 3B is a diagram illustrating a manufacturing method of a liquid immersion portion.
FIG. 3C is a diagram illustrating a manufacturing method of the liquid immersion portion.
FIG. 4A is a diagram illustrating an example of the porous member.
FIG. 4B is a diagram illustrating an example of the porous member.
FIG. 4C is a diagram illustrating an example of the porous member.
FIG. 5 is a side cross-sectional view illustrating the vicinity of the liquid immersion member.
FIG. 6 is a side cross-sectional view illustrating the vicinity of the liquid immersion member.
FIG. 7 is a side cross-sectional view illustrating the vicinity of the liquid immersion member.
FIG. 8 is a flowchart illustrating an example of the micro-device manufacturing process.
FIG. 9A is a graph illustrating a film thickness distribution of the ta-C film formed according to the embodiment.
FIG. 9B is a graph illustrating a film thickness distribution of the ta-C film formed according to the embodiment.

### Description of Embodiments

Hereinafter, embodiments of the present invention will be described with reference to the drawings, and the present invention is not limited thereto. In addition, in the following description, an XYZ rectangular coordinate system is set, and a positional relationship of each member is described with reference to the XYZ rectangular coordinate system. In addition, a predetermined direction in the horizontal plane is set as the X axis direction, a direction (that is, a vertical direction) perpendicular to the X axis direction is set as the Y axis direction, and a direction perpendicular to the X axis direction and the Y axis direction is set as the Z axis direction. In addition, rotation (inclined) directions around the X axis, the Y axis and the Z axis are respectively assumed as θX, θY, and θZ directions.

### First Embodiment

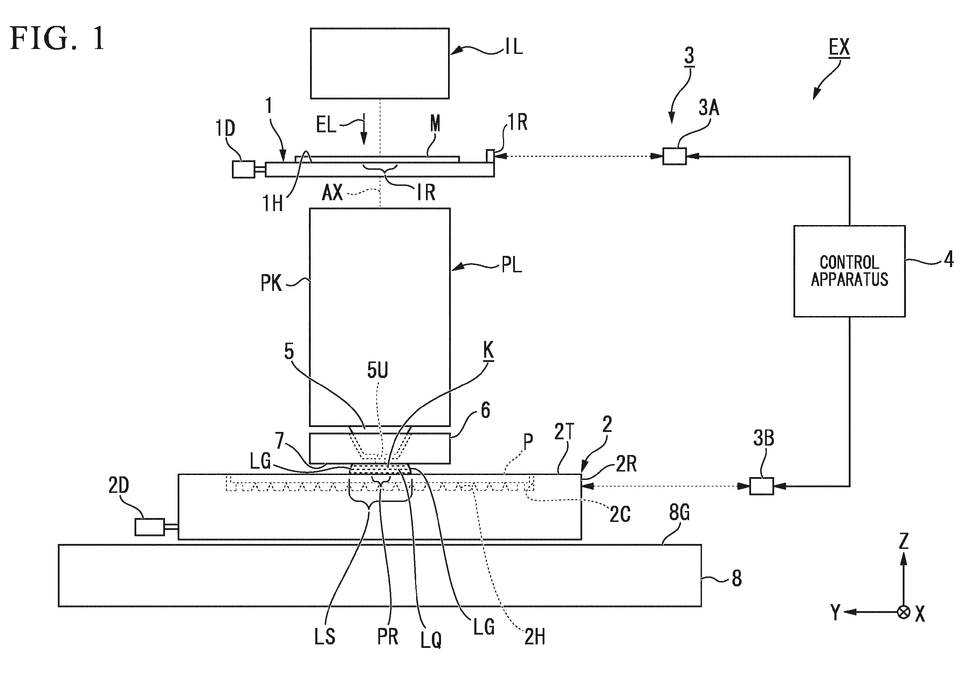

The first embodiment will be described. FIG. 1 is a schematic configuration diagram illustrating an example of the exposure apparatus EX according to the first embodiment. In FIG. 1, the exposure apparatus EX includes a mask stage 1 which can hold and move a mask M, a substrate stage 2 which can hold and move a substrate P, a first driving system 1D which moves the mask stage 1, a second driving system 2D which moves the substrate stage 2, an interferometer system 3 which can measure positional information of each of the mask stage 1 and the substrate stage 2, an illumination system IL which illuminates the mask M with exposure light EL, a projection optical system PL which projects an image of a pattern of the mask M illuminated with the exposure light EL onto the substrate P, and a control apparatus 4 which controls the operation of the entire exposure apparatus EX.

The mask M includes a reticle on which a device pattern projected onto the substrate P is formed. The mask M includes a transmissive mask where a predetermined pattern is formed using a light blocking layer such as chrome on a transparent plate such as, for example, a glass plate. In addition, a reflective mask may be used as the mask M. The substrate P is a substrate for manufacturing a device. The substrate P includes a substrate where a photosensitive film is formed on a base material such as a semiconductor wafer like, for example, a silicon wafer. The photosensitive film is a film of a sensitive material (photoresist). In addition, the substrate P may include the photosensitive film and other films. For example, the substrate P may include an anti-reflection film or may include a protective film (overcoat film) for protecting the photosensitive film.

The exposure apparatus EX according to the present invention is a liquid immersion exposure apparatus which exposures the substrate P to the exposure light EL via the liquid LQ. The exposure apparatus EX includes a liquid immersion member 6 which can form a liquid immersion space LS such that at least a part of the optical path K of the exposure light EL is filled with the liquid LQ. The liquid immersion space LS is a space filled with the liquid LQ. In the present embodiment, water (pure water) is used as the liquid LQ.

In the present embodiment, the liquid immersion space LS is formed such that the optical path K of the exposure light EL emitted from a longitudinal optical element 5 closest to the upper surface of the projection optical system PL among a plurality of optical elements of the projection optical system PL is filled with the liquid LQ. The longitudinal optical element 5 has an emission surface 5U which emits the exposure light EL toward the upper surface of the projection optical system PL. The liquid immersion space LS is formed such that the optical path K between the longitudinal optical element 5 and an object disposed at a position opposite to the emission surface 5U of the longitudinal optical element 5 is filled with the liquid LQ. The position opposite to the emission surface 5U includes an irradiation position of the exposure light EL emitted from the emission surface 5U.

The liquid immersion member 6 is disposed around the longitudinal optical element 5. The liquid immersion member 6 has a lower surface 7. In the present embodiment, an object, which can be opposite to the emission surface 5U, can be opposite to the lower surface 7. When a surface of the object is disposed at a position opposite to the emission surface 5U, at least a part of the lower surface 7 is opposite to the surface of the object. When the surface of the object is opposite to the emission surface 5U, the liquid LQ can be held between the emission surface 5U and the surface of the object. In addition, when the lower surface 7 of the liquid immersion member 6 is opposite to the surface of the object, the liquid LQ can be held between the lower surface 7 and the surface of the object. The liquid immersion space LS is formed by the liquid LQ held between the emission surface 5U and the lower surface 7 in one side and the surface of the object in the other side.

In the present embodiment, an object which can be opposite to the emission surface 5U and the lower surface 7 includes an object which can move on the emission side (upper surface side) of the longitudinal optical element 5, and includes an object which can move to a position opposite to the emission surface 5U and the lower surface 7. In the present embodiment, the object includes at least one of the substrate stage 2 and the substrate P held at the substrate stage 2. In addition, in the following, for simplification of description, a state where the emission surface 5U and the lower surface 7 in one side and the surface of the substrate P in the other side are opposite to each other will be mainly described an example. However, this is also the same for a case where the emission surface 5U and the lower surface 7 in one side and the surface of the substrate stage 2 in the other side are opposite to each other.

In the present embodiment, the liquid immersion space LS is formed such that a partial region (local region) of the surface of the substrate P disposed at a position opposite to the emission surface 5U and the lower surface 7 is covered with the liquid LQ, and an interface (meniscus, edge) LG of the liquid LQ is formed between the surface of the substrate P and the lower surface 7. That is to say, in the present embodiment, the exposure apparatus EX employs a local liquid immersion method in which the liquid immersion space LS is formed such that a partial region on the substrate P including a projection region PR of the projection optical system PL is covered with the liquid LQ during exposure of the substrate P.

The illumination system IL illuminates a predetermined illumination region IR with the exposure light EL of uniform illuminance distribution. The illumination system IL illuminates at least a part of the mask M disposed in the illumination region IR with the exposure light EL of uniform illuminance distribution. As the exposure light EL emitted from the illumination system IL, for example, far-ultraviolet light (DUV light) such as luminescent rays (g rays, h rays, i rays) emitted from a mercury lamp and KrF excimer laser light (wavelength 248 nm), and vacuum-ultraviolet light (VUV light) such as ArF excimer laser light (wavelength 193 nm) and F₂ laser light (wavelength 157 nm) are used. In the present embodiment, the ArF excimer laser light which is ultraviolet light (vacuum ultraviolet light) is used as the exposure light EL.

The mask stage 1 includes a mask holding portion 1H which holds the mask M. The mask M is attachable to and detachable from the mask holding portion 1H. In the present embodiment, the mask holding portion 1H holds the mask M such that a pattern formation surface (lower surface) of the mask M is substantially parallel to the XY plane. The first driving system 1D includes an actuator such as a linear motor. The mask stage 1 can hold the mask M and move in the XY plane through an operation of the first driving system 1D. In the present embodiment, the mask stage 1 can move in the X axis, Y axis and θZ directions in a state where the mask M is held by the mask holding portion 1H.

The projection optical system PL applies the exposure light EL to the predetermined projection region PR. The projection optical system PL projects an image of the pattern of the mask M onto at least a part of the substrate P disposed at the projection region PR at a predetermined projection magnification. A plurality of optical elements of the projection optical system PL are held at a lens barrel PK. The projection optical system PL according to the present embodiment is a reduction system which has the projection magnification of, for example, 1/4, 1/5, 1/8, or the like. In addition, the projection optical system PL may be an actual size system or an enlargement system. In the present embodiment, an optical axis AX of the projection optical system PL is substantially parallel to the Z axis. In addition, the projection optical system PL may be a refractive system which does not include a reflective optical element, a reflective system which does not include a refractive optical element, or a catadioptric system which includes a reflective optical system and a refractive optical system. Further, the projection optical system PL may form an inverted image or an erected image.

The substrate stage 2 can move on a guide surface 8G of a base member 8. In the present embodiment, the guide surface 8G is substantially parallel to the XY plane. The substrate stage 2 can hold the substrate P and move in the XY plane along the guide surface 8G.

The substrate stage 2 has a substrate holding portion 2H which holds the substrate P. The substrate holding portion 2H can hold the substrate P so as to be released. In the present embodiment, the substrate holding portion 2H holds the substrate P such that an exposure surface (surface) of the substrate P is substantially parallel to the XY plane. The second driving system 2D includes an actuator such as a linear motor. The substrate stage 2 can hold the substrate P and move in the XY plane through an operation of the second driving system 2D. In the present embodiment, the substrate stage 2 can move in the X axis, Y axis, Z axis, θX, θY and θZ directions in a state where the substrate holding portion 2H holds the substrate P.

The substrate stage 2 includes an upper surface 2T disposed around the substrate holding portion 2H. In the present embodiment, the upper surface 2T is flat and substantially parallel to the XY plane. Further, the substrate stage 2 includes a recessed portion 2C. The substrate holding portion 2H is disposed inside the recessed portion 2C. In the present embodiment, the upper surface 2T and the surface of the substrate P disposed at the substrate holding portion 2H are disposed in almost the same plane (coplanar).

The interferometer system 3 measures positional information of each of the mask stage 1 and the substrate stage 2 in the XY plane. The interferometer system 3 includes a laser interferometer 3A which measures positional information of the mask stage 1 in the XY plane and a laser interferometer 3B which measures positional information of the substrate stage 2 in the XY plane. The laser interferometer 3A irradiates a reflection surface 1R disposed at the mask stage 1 with measurement light, and measures positional information of the mask stage 1 (the mask M) regarding the X axis, Y axis and θZ directions by the use of the measurement light via the reflection surface 1R. The laser interferometer 3B irradiates a reflection surface 2R disposed at the substrate stage 2 with measurement light, and measures positional information of the substrate stage 2 (the substrate P) regarding the X axis, Y axis and θZ directions by the use of the measurement light via the reflection surface 2R.

In addition, in the present embodiment, a focus and leveling detection system (not shown) which detects positional information of the surface of the substrate P held at the substrate stage 2 is disposed. The focus and leveling detection system detects positional information of the surface of the substrate P regarding the Z axis, θX and θY directions.

When the substrate P is exposed, positional information of the mask stage 1 is measured by the laser interferometer 3A, and positional information of the substrate stage 2 is measured by the laser interferometer 3B. The control apparatus 4 operates the first driving system 1D on the basis of the measurement result from the laser interferometer 3A and executes the positional information of the mask M held at the mask stage 1. In addition, the control apparatus 4 operates the second driving system 2D on the basis of the measurement result from the laser interferometer 3B and the detection result from the focus and leveling detection system, and executes the positional information of the substrate P held at the substrate stage 2.

The exposure apparatus EX according to the present embodiment is a scanning type exposure apparatus (a so-called scanning stepper) which moves the mask M and the substrate P in synchronization with each other in a predetermined scanning direction and projects an image of a pattern of the mask M onto the substrate P. When the substrate P is exposed, the control apparatus 4 controls the mask stage 1 and the substrate stage 2 such that the mask M and the substrate P are moves in a predetermined scanning direction in the XY plane which intersects the optical path K (optical axis AX) of the exposure light EL. In the present embodiment, it is assumed that the scanning direction (synchronous movement direction) of the substrate P is the Y axis direction, and the scanning direction (synchronous movement direction) of the mask M is also the Y axis direction. The control apparatus 4 moves the substrate P in the Y axis direction with respect to the projection region PR of the projection optical system PL, and irradiates the substrate P with the exposure light EL via the projection optical system PL and the liquid LQ of the liquid immersion space LS on the substrate P while moving the mask M in the Y axis direction with respect to the illumination region IR of the illumination system IL in synchronization with the movement of the substrate P in the Y axis direction. Thereby, the substrate P is exposed to the exposure light EL, and thus the image of the pattern of the mask M is projected onto the substrate P.

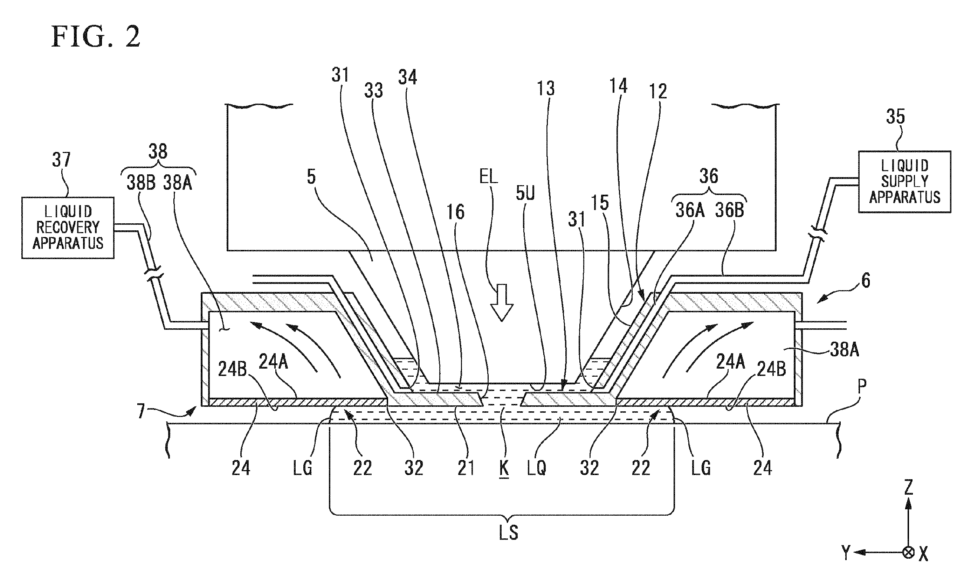

Next, an example of the liquid immersion member 6 according to the present embodiment and a method for manufacturing the liquid immersion member 6 will be described with reference to the drawings. FIG. 2 is a side cross-sectional view illustrating the vicinity of the liquid immersion member 6.

In addition, although, in the following description, a case where the surface of the substrate P is disposed at a position opposite to the emission surface 5U of the longitudinal optical element 5 and the lower surface 7 of the liquid immersion member 6 is described as an example, objects other than the substrate P such as the upper surface 2T of the substrate stage 2 may be disposed at the position opposite to the emission surface 5U of the longitudinal optical element 5 and the lower surface 7 of the liquid immersion member 6, as described above. Further, in the following description, the emission surface 5U of the longitudinal optical element 5 is appropriately referred to as a lower surface 5U of the longitudinal optical element 5.

The liquid immersion member 6 can form the liquid immersion space LS such that the optical path K of the exposure light EL between the longitudinal optical element 5 and the substrate P is filled with the liquid LQ. In the present embodiment, the liquid immersion member 6 is a ring-shaped member (a ring-shaped member when the exterior thereof is viewed in the Z axis direction), and is disposed so as to surround the optical path K of the exposure light EL. In the present embodiment, the liquid immersion member 6 includes a side plate portion 12 which is disposed around the longitudinal optical element 5 and a lower plate portion 13 which has at least a part disposed between the lower surface 5U and the longitudinal optical element 5 and the surface of the substrate P in the Z axis direction.

Further, the liquid immersion member 6 may be a member having a shape other than a ring shape. For example, the liquid immersion member 6 may be disposed at a part of the vicinity of the optical path K of the exposure light EL emitted from the longitudinal optical element 5 and the emission surface 5U.

The side plate portion 12 is opposite to an outer circumferential surface 14 of the longitudinal optical element 5, and a predetermined gap is formed between the outer circumferential surface and an inner circumferential surface 15 therealong.

The lower plate portion 13 has an opening 16 at the center. The exposure light EL emitted from the lower surface 5U can pass through the opening 16. For example, during the exposure of the substrate P, the exposure light EL emitted from the lower surface 5U passes through the opening 16, and is applied to the surface of the substrate P via the liquid LQ. In the present embodiment, the cross-sectional shape of the exposure light EL in the opening 16 is a rectangular shape (slit shape) which is long in the X axis direction. The opening 16 has a shape corresponding to the cross-sectional shape of the exposure light EL. That is to say, a shape of the opening 16 in the XY plane is a rectangular shape (slit shape). In addition, the cross-sectional shape of the exposure light EL in the opening 16 is almost the same as the shape of the projection region PR of the projection optical system PL in the substrate P.

In addition, the liquid immersion member 6 includes a supply hole 31 which supplies the liquid LQ for forming the liquid immersion space LS and a recovery hole 32 which sucks and recovers at least some of the liquid LQ on the substrate P.

In the present embodiment, the lower plate portion 13 of the liquid immersion member 6 is disposed around the optical path of the exposure light EL. An upper surface 33 of the lower plate portion 13 faces toward the + Z axis direction, and the upper surface 33 is opposite to the lower surface 5U via a predetermined gap. The supply hole 31 can supply the liquid LQ to an inner space 34 between the lower surface 5U and the upper surface 33. In the present embodiment, the supply hole 31 is disposed at each side in the Y axis direction with respect to the optical path K.

The supply hole 31 is connected to a liquid supply apparatus 35 via a flow channel 36. The liquid supply apparatus 35 can send out the clean liquid LQ of which temperature is adjusted. The flow channel 36 includes a supply flow channel 36A formed inside the liquid immersion member 6, and a flow channel 36B formed by a supply tube for connecting the supply flow channel 36A to the liquid supply apparatus 35. The liquid LQ sent out from the liquid supply apparatus 35 is supplied to the supply hole 31 via the flow channel 36. The supply hole 31 supplies the liquid LQ from the liquid supply apparatus 35 to the optical path K.

The recovery hole 32 is connected to a liquid recovery apparatus 37 via a flow channel 38. The liquid recovery apparatus 37 includes a vacuum system and can suck and recover the liquid LQ. The flow channel 38 includes a recovery flow channel 38A formed inside the liquid immersion member 6, and a flow channel 38B formed by a recovery tube for connecting the recovery flow channel 38A to the liquid recovery apparatus 37. The liquid recovery apparatus 37 is operated, and thereby the liquid LQ recovered from the recovery hole 32 is recovered to the liquid recovery apparatus 37 via the flow channel 38.

In the present embodiment, the recovery hole 32 of the liquid immersion member 6 is provided with a porous member 24. At least some of the liquid LQ between the recovery hole and the substrate P is recovered via the recovery hole 32 (porous member 24). The lower surface 7 of the liquid immersion member 6 includes a land surface 21 disposed around the optical path K of the exposure light EL, and a liquid recovery region 22 provided outside the land surface 21 with respect to the optical path K of the exposure light EL. In the present embodiment, the liquid recovery region 22 includes a surface (lower surface) of the porous member 24.

In the following description, the liquid recovery region 22 is appropriately referred to as a recovery surface 22.

The land surface 21 can hold the liquid LQ between it and the surface of the substrate P. In the present embodiment, the land surface 21 faces toward the -Z axis direction, and includes the lower surface of the lower plate portion 13. The land surface 21 is disposed around the opening 16. In the present embodiment, the land surface 21 is flat and is substantially parallel to the surface (XY plane) of the substrate P. In the present embodiment, the exterior of the land surface 21 in the XY plane has a rectangular shape, but may have other shapes, for example, a circular shape.

The recovery surface 22 can recover at least some of the liquid LQ between the lower surface 5U and the lower surface 7 in one side and the surface of the substrate P in the other side. The recovery surface 22 is disposed at both sides in the Y axis direction (scanning direction) with respect to the optical path K of the exposure light EL. In the present embodiment, the recovery surface 22 is disposed around the optical path K of the exposure light EL. That is to say, the recovery surface 22 is disposed in a rectangular ring shape around the land surface 21. In addition, in the present embodiment, the land surface 21 and the recovery surface 22 are disposed in almost the same plane (coplanar). Further, the land surface 21 and the recovery surface may not be disposed in the same plane.

The recovery surface 22 includes the surface (lower surface) of the porous member 24, and recovers the liquid LQ coming into contact with the recovery surface 22 via holes of the porous member 24.

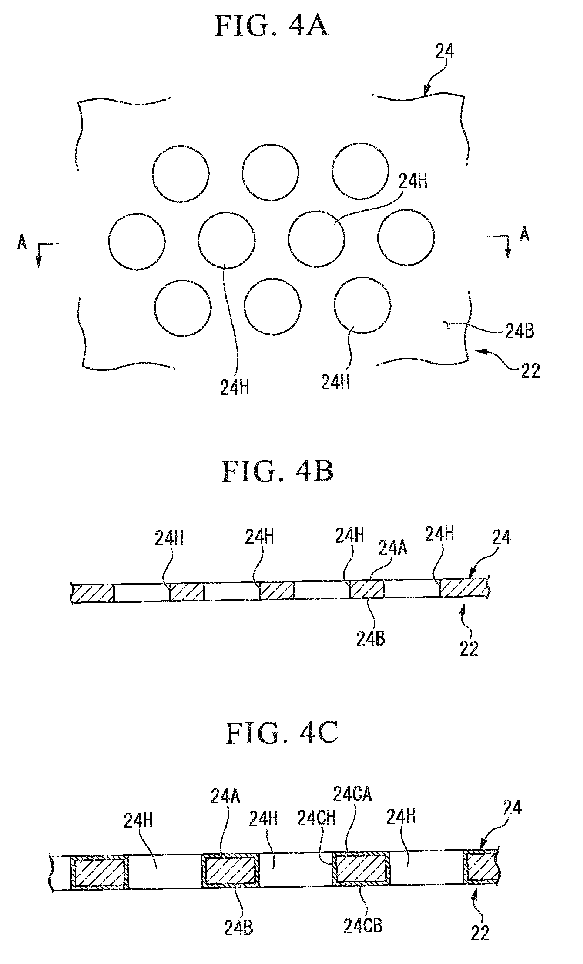

FIG. 4A is a plan view enlarging the porous member 24 according to the present embodiment, and FIG. 4B is a cross-sectional fragmentary view taken along the line A-A in FIG. 4A. As shown in FIGS. 4A and 4B, in the present embodiment, the porous member 24 is a thin plate member where a plurality of small holes 24H are formed. The porous member 24 is a member where a thin plate member is processed so as to form a plurality of holes 24H, and is also referred to as a mesh plate.

The porous member 24 has a lower surface 24B opposite to the surface of the substrate P and an upper surface 24A located at an opposite side to the lower surface 24B. The lower surface 24B forms the recovery surface 22. The upper surface 24A comes into contact with the recovery flow channel 38A. The holes 24H are formed between the upper surface 24A and the lower surface 24B. In other words, the holes 24H are formed so as to penetrate through the upper surface 24A and the lower surface 24B. In the following description, the holes 24H are appropriately referred to as through-holes 24H.

In the present embodiment, the upper surface 24A and the lower surface 24B are substantially parallel to each other. In other words, in the present embodiment, the upper surface 24A and the lower surface 24B are substantially parallel to the surface (XY plane) of the substrate P. In the present embodiment, the through-holes 24H penetrates between the upper surface 24A and the lower surface 24B so as to be substantially parallel to the Z axis direction. The liquid LQ can flow through the through-holes 24H. The liquid LQ on the substrate P are attracted to the recovery flow channel 38A via the through-holes 24H.

In the present embodiment, a shape of the through-hole (opening) 24H in the XY plane is a circular shape. In addition, the size of the through-hole (opening) 24H in the upper surface 24A is substantially the same as the size of the through-hole (opening) 24H in the lower surface 24B. Further, a shape of the through-hole 24H in the XY plane may be a shape other than the circular shape, for example, a polygonal shape such as a pentagonal shape or a hexagonal shape. In addition, the diameter or the shape of the through-hole (opening) 24H in the upper surface 24A may be different from the diameter or the shape of the through-hole (opening) 24H in the lower surface 24B.

In the present embodiment, the control apparatus 4 generates a pressure difference between the upper surface 24A and the lower surface 24B of the porous member 24 by operating the liquid recovery apparatus 37 including the vacuum system, thereby recovering the liquid LQ from the porous member 24 (the recovery surface 22). The liquid LQ recovered from the recovery surface 22 is recovered to the liquid recovery apparatus 37 via the flow channel 38.

When the substrate P is exposed, there is a possibility that substances (for example, organic substances such as a resist or an overcoat) which have eluted to the liquid LQ from the substrate P may be reprecipitated on a member surface forming the liquid immersion member 6. When the precipitate is generated in a region where the liquid immersion member 6 comes into contact with the liquid LQ, the precipitate may possibly be peeled by liquid current (water current) and adhered to the substrate P.

In the present embodiment, an amorphous carbon film (hereinafter, referred to as an "a-C film") is formed in at least a part of the region where the liquid immersion member 6 comes into contact with the liquid LQ. The a-C film is chemically inactive, and has a property that the mechanical strength is good since adhesion to a foundation (base material) on which the film is formed is excellent. For this reason, in the present embodiment, the region where the a-C film is formed has low chemical affinity with the resist component and/or the overcoat component which has eluted in the liquid LQ coming into therewith in the liquid immersion member 6. In the region where the film is formed, even if repeatedly wet by the liquid LQ and dried, it is difficult for adhesion and reprecipitation of the resist component and/or the overcoat component in the liquid LQ to occur. Therefore, it is possible to effectively suppress exposure defects generated because the overcoat component is reprecipitated on the surface of the liquid immersion member 6 of the region coming into contact with the liquid LQ, and the precipitate is peeled and is adhered to the surface of the substrate P during exposure.

In the present embodiment, a preferred portion where the a-C film is formed on a surface thereof is not particularly limited as long as it comes into contact with the liquid LQ in the liquid immersion member 6. For example, the a-C film may be formed on at least a part of a region coming into contact with the liquid LQ in the liquid recovery region 22 (the recovery hole 32 and the porous member 24), the land surface 21, the lower plate portion 13, and the side plate portion 14. In addition, among the members forming the liquid immersion member 6, the a-C film may be formed on at least a region where reprecipitation of the resist component and/or the overcoat component is apt to occur or a region which is apt to be influenced by flow current of the liquid LQ. With such a configuration, it is possible to suppress reprecipitation of the resist component and/or the overcoat component and to thereby suppress peeling of the precipitate and adhesion to the substrate P.

The above-described region where reprecipitation of the resist component and/or the overcoat component is apt to occur or the above-described region which is apt to be influenced by flow current of the liquid LQ may include, particularly the recovery hole 32 (the porous member 24) of the liquid recovery region 22. If the a-C film is formed on the surface of the recovery hole 32 (the porous member 24), it is possible to effectively suppress reprecipitation of the resist component and/or the overcoat component, peeling of the precipitate, and adhesion of the precipitate to the substrate P and to thereby suppress exposure defects.

Further, according to the present embodiment, since it is difficult for reprecipitation of the resist component and/or the overcoat component to be generated in the liquid immersion member 6, it is possible to reduce the frequency of cleaning tasks for the liquid immersion member 6. In addition, if the a-C film is formed on the surface of the liquid immersion member 6, even if reprecipitation of the resist component and/or the overcoat component occurs through repeated exposure processes, chemical affinity between the surface of the liquid immersion member 6 and the resist component and/or the overcoat component is low, and thus the adhesion thereof is weak and time for cleaning works for the precipitate can be reduced. Therefore, according to the present embodiment, since it is possible to reduce the frequency of and the time for the cleaning tasks, it is possible to shorten downtime of the liquid immersion exposure apparatus and to thereby suppress reduction in productivity.

In the present embodiment, a base material of the liquid immersion member 6 is made of Ti (titanium). In addition, the base material of the liquid immersion member 6 may be made of corrosion-resistant metal such as stainless steel or Al, or ceramics. The film thickness of the a-C film formed on at least a part of the liquid immersion member 6 is not particularly limited, is preferably 5 nm or more, and is more preferably 10 nm to 1 µm. For example, the film thickness of the a-C film may be 5, 6, 7, 8, 9, 10, 20, 30, 40, 50, 60, 70, 80, 90, 100, 200, 300, 400, 500, 600, 700, 800, 900, or 1000 nm. The a-C film is preferably a tetrahedral amorphous carbon film (hereinafter, referred to as a "ta-C film") which does not almost include hydrogen in the film and has a high carbon sp³ ratio (about 50 to 85 %).

FIG. 4C is a cross-sectional fragmentary view illustrating an example of the case where the a-C film is formed on the porous member 24 of the recovery hole 32.

In the present embodiment, as shown in FIG. 4C, the a-C films are formed on the lower surface 24B, the inner wall surfaces of the through-holes 24H, and the upper surface 24A. The film thicknesses of the a-C films on the lower surface 24B, the inner surfaces of the through-holes 24H, and the upper surface 24A are not particularly limited, and are preferably 5 nm or more and more preferably 10 nm to 1 µm, and a film may be formed continuously instead of an island shape in order to achieve an effect according to formation of a chemically inactive a-C film. For example, the film thickness of the a-C film may be 5, 6, 7, 8, 9, 10, 20, 30, 40, 50, 60, 70, 80, 90, 100, 200, 300, 400, 500, 600, 700, 800, 900, or 1000 nm. The film thicknesses of the a-C films formed on the lower surface 24B, the upper surface 24A, and the inner surfaces of the through-holes 24H may be the same as or different from each other. The film thickness of the a-C film on the inner surface of the through-hole 24H may be appropriately adjusted according to the hole diameter of the through-hole 24H. In addition, the a-C film may be formed only on the lower surface 24B and/or the upper surface 24A.

In the present embodiment, the liquid immersion member 6 may be manufactured by forming the a-C film on at least a part of a region coming into contact with the liquid LQ in the liquid immersion member 6 using a CVD method (Chemical Vapor Deposition method) or a PVD method (Physical Vapor Deposition method).

The CVD method may include well-known methods in the related art as a method of forming the a-C film, for example, a microwave plasma CVD method, a DC plasma CVD method, a high frequency CVD method, a magneto-active plasma CVD method, and the like.

The PVD method may include well-known methods in the related art as a method of forming the a-C film, for example, an ion beam deposition method, an ion beam sputtering method, a magnetron sputtering method, a laser deposition method, a laser sputtering method, an arc ion plating method, a filtered cathodic vacuum arc method (FCVA method), and the like.

Among these film forming methods, the FCVA method is particularly preferable since the adhesion is good even at room temperature and uniform coating is possible even for a base material with a complicated shape.

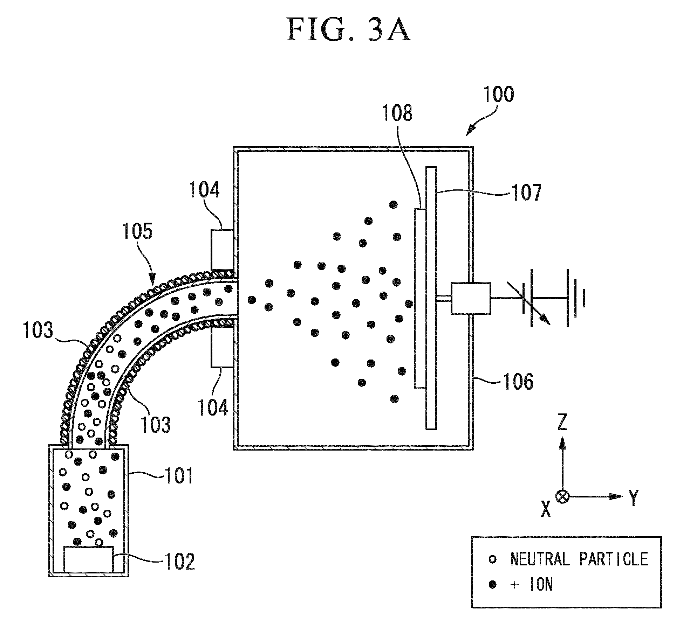

The FCVA method is a film forming method where ionized particles are generated through arc discharge of a target, and a film is formed by attracting only the particles to a substrate. FIG. 3A is a schematic configuration diagram of an FCVA apparatus 100. In the FCVA apparatus 100, an arc plasma generation chamber 101 in which a graphite target 102 is installed and a film forming chamber 106 are connected to each other via a spatial filter 105. The film forming chamber 106 includes a substrate holder 107 therein, and the substrate holder 107 fixes a substrate 108 such that the substrate 108 can be inclined in the θX direction or be rotated in the θY direction by driving means (not shown). The spatial filter 105 double-bends in the -X axis direction and the Y axis direction, an electromagnet coil 103 is wound on the periphery thereof, and an ion scan coil 104 is wound on the vicinity of a communication portion with the film forming chamber 106.

If the a-C film is to be formed using the FCVA method, first, arc discharge is caused by applying a DC voltage to the graphite target 102 in the arc plasma generation chamber 101, thereby generating arc plasma. Neutral particles, C⁺ ions, and other ions in the generated arc plasma are transported to the spatial filter 105, the neutral particles and the ions having different mass are trapped by the electromagnet coil 103 and the ion scan coil 104 in the process of passing through the spatial filter 105, and only the C⁺ ions are attracted into the film forming chamber 106. A negative bias voltage is applied to the substrate 108 in the film forming chamber 106 by control means (not shown). The C⁺ ions obtained through the arc discharge are accelerated by the bias voltage and are bonded onto the substrate 108. There are both the sp² bonding and the sp³ bonding in a structure thereof, and sp³-C can be rich and an a-C film and a ta-C film can be formed in the FCVA method by controlling the bias voltage. Specifically, in the FCVA method, an a-C film having sp³-C of 85 to 60% and sp²-C of 15 to 40% can be formed by adjusting the bias voltage.

In the FCVA method, only the C⁺ ions having the flight energy are attracted into the film forming chamber 106, and it is possible to control the ion impact energy of the C⁺ ion particles incident to the substrate 108 by controlling the bias voltage applied to the substrate 108. Therefore, it is possible to form a uniform film even on the substrate 108 with a complicated shape.

In the present embodiment, as shown in FIG. 4C, when the a-C film and the ta-C film are formed on the porous member 24 of the recovery hole 32, the films can be uniformly formed on the inner wall surfaces of the fine through-holes 24H, and thus the films are preferably formed using the FCVA method.

As shown in FIG. 4C, a description will be made of a method of forming the a-C films (the ta-C films) on the upper surface 24A and the lower surface 24B of the porous member 24 and the inner wall surfaces of the through-holes 24H using the FCVA method.

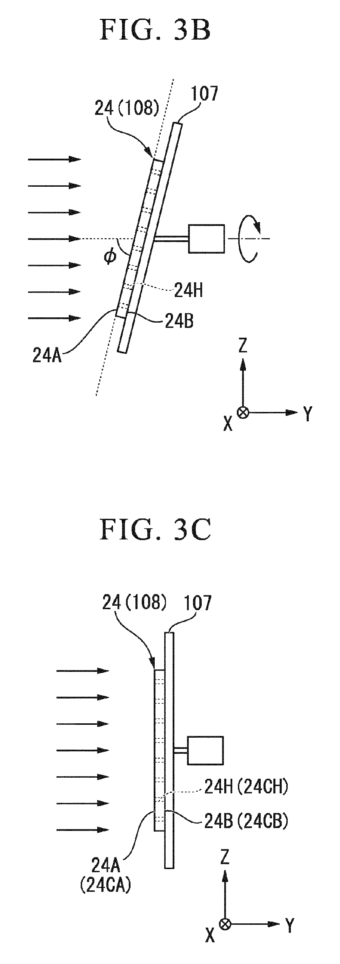

First, the porous member 24 is installed at the substrate holder 107 such that the upper surface 24A of the porous member 24 is opposite to a flight direction (Y axis direction) of the C⁺ ion particles. Next, as shown in FIG. 3B, through an operation of the substrate holder 107 using driving means (not shown), the porous member 24 is rotated in the θX direction, and the plane of the upper surface 24A is inclined so as to form an angle Φ with respect to the Y axis which is the flight direction of the C⁺ ions (an incidence angle of the C⁺ ions to the upper surface 24A of the porous member 24 is Φ). In addition, while the substrate holder 107 is rotated in the θY direction by the driving means (not shown), a-C films (ta-C films) is formed. As such, the porous member 24 is installed and rotated so as to form the film, and thus the C⁺ ions reach the inner wall surfaces of the through-holes 24H as well as the upper surface 24A of the porous member 24, thereby forming the a-C films (ta-C films). In addition, the inclined angle with respect to the Y axis (the flight direction of the C⁺ ions) of the plane of the upper surface 24A of the porous member 24 is not particularly limited as long as it is an angle where the C⁺ ions reach up to the insides of the through-holes 24H of the porous member 24 and thus the a-C films (ta-C films) can be formed on the inner wall surfaces of the through-holes 24H, and, for example, it may be 45 degrees.

After the a-C films (ta-C films) are formed on the upper surface 24A side of the porous member 24, the porous member 24 is separated from the substrate holder 107, and the porous member 24 where one surface (the upper surface 24A) is provided with the films is then installed at the substrate holder 107 such that the lower surface 24B is opposite to the flight direction (the Y axis direction) of the C⁺ ion particles. Next, while the porous member 24 is rotated in the θY direction at an inclined angle (an incidence angle of the C⁺ ions to the lower surface 24B of the porous member 24) Φ in the same procedure as in the above-described film forming method on the upper surface 24A side, the a-C films (ta-C films) are formed on the lower surface 24B side. The inclined angle Φ of the plane of the lower surface 24B with respect to the Y axis when the a-C films (ta-C films) are formed on the lower surface 24B side of the porous member 24 is preferably the same as the inclined angle Φ of the plane of the lower surface 24B with respect to the Y axis when the films are formed on the upper surface 24A side. If the porous member 24 is installed and the films are formed such that the inclined angle Φ when the films are formed on the upper surface 24A side is the same as the inclined angle Φ when the films are formed on the lower surface 24B side, the film thicknesses of the a-C films (ta-C films) formed on the inner wall surfaces of the through-holes 24H can be made uniform. The a-C films (ta-C films) are formed on the upper surface 24A and the lower surface 24B of the porous member 24 and the inner wall surfaces of the through-holes 24H using the above-described method, and thereby it is possible to manufacture the liquid immersion member 6 according to the present embodiment.

In the liquid immersion member 6 according to the present embodiment, the region of which the a-C film is formed on the surface is liquid-repellent, but at least a part of the a-C film is preferably lyophilic in order to hold the liquid LQ, form the liquid immersion space LS, and smoothly perform supply and recovery of the liquid LQ. In addition, in the present embodiment, the term "liquid-repellent" indicates that a contact angle when pure water is dropped on the surface exceeds 50 degrees, and the term "lyophilic" indicates that a contact angle when pure water is dropped on the surface is equal to or less than 50 degrees.

If the region of the liquid immersion member 6 provided with the a-C film is to be changed from liquid repellency to lyophilic, a region which is desired to be lyophilic in the region provided with the a-C film is irradiated with ultraviolet rays in air, thereby adding the OH radical to the irradiated surface.

The liquid immersion member 6 according to the present embodiment is preferable since the liquid-repellent a-C film is formed on the region coming into contact with the interface LG of the liquid LQ so as to prevent wetting and spreading of the liquid LQ, and thereby the area of a region where the overcoat component in the liquid LQ is reprecipitated low.

In the present embodiment, in the porous member 24 which is the recovery hole 32 of the liquid recovery region 22, preferably, the a-C film (ta-C film) 24CA (hereinafter, referred to as a film-formed surface 24CA) on the upper surface 24A and the a-C film (ta-C film) 24CB (hereinafter, referred to as a film-formed surface 24CB) on the lower surface 24B are liquid-repellent. In addition, the a-C films (ta-C films) 24CH (hereinafter, referred to as film-formed surfaces 24CH) on the inner wall surfaces of the through-holes 24H are preferably lyophilic such that the liquid LQ on the substrate P is transmitted from the lower surface 24B side to the upper surface 24A side and then the liquid LQ is recovered.

In order to manufacture such a porous member 24, first, the a-C films (ta-C films) are formed on the upper surface 24A, the lower surface 24B and the inner wall surfaces of the through-holes 24H using the above-described method, and then the film-formed surface 24CA, the film-formed surface 24CB, and the film-formed surfaces 24CH are made to be liquid-repellent. Next, the overall porous member 24 is irradiated with ultraviolet rays in air, and thereby the film-formed surface 24CA, the film-formed surface 24CB, and the film-formed surfaces 24CH are made to be lyophilic. The obtained porous member 24 is installed at the substrate holder 107 of the FCVA apparatus, as shown in FIG. 3C, such that the upper surface 24A (the film-formed surface 24CA) is opposite to the flight direction (the Y axis direction) of the C⁺ ions and the plane of the upper surface 24A (the film-formed surface 24CA) is parallel to the Z axis, and the a-C film (ta-C film) is formed only with the thickness of, for example, 5 nm, and the film-formed surface 24CA is made to be liquid-repellent. Next, the a-C film (ta-C film) is formed on the film-formed surface 24CB only with the thickness of, for example, 5 nm, in the same manner as the film-formed surface 24CA, and the film-formed surface 24CB is made to be liquid-repellent.

Through the procedure and method, only the film-formed surfaces 24CH which are the a-C films (ta-C films) formed on the inner wall surfaces of the through-holes 24H can be made to be lyophilic, and only the film-formed surface 24CA and the film-formed surface 24CB can be made to be liquid-repellent. With the porous member 24 of such a configuration, since the lower surface 24B coming into contact with the liquid LQ is appropriately liquid-repellent, wetting and spreading of the interface LQ of the liquid LQ are prevented, and thus it is possible to decrease a reprecipitated region of the resist component and/or the overcoat component in addition to the effect of suppressing reprecipitation of the resist component and/or the overcoat component by the formation of the a-C films (ta-C films). In addition, since the inner wall surfaces of the through-holes 24H are lyophilic, the liquid LQ can be smoothly transmitted therethrough and recovered in addition to the effect of suppressing reprecipitation of the resist component and/or the overcoat component by the formation of the a-C films (ta-C films).

As described above, according to the liquid immersion member of the present embodiment, since the a-C film is formed on at least a part of the region coming into contact with the liquid LQ of the liquid immersion member 6, the region where the a-C film is formed has low chemical affinity with the resist component and/or the overcoat component which has eluted in the liquid LQ coming into therewith, and even if repeatedly wet by the liquid LQ and dried, it is difficult for adhesion and reprecipitation of the resist component and/or the overcoat component in the liquid LQ to occur. Therefore, it is possible to effectively suppress exposure defects generated because the resist component and/or the overcoat component are/is reprecipitated on the surface of the liquid immersion member 6 of the region coming into contact with the liquid LQ, and the precipitate is peeled and is adhered to the surface of the substrate P during exposure.

Further, according to the liquid immersion member of the present embodiment, since it is difficult for reprecipitation of the resist component and/or the overcoat component to be generated in the liquid immersion member 6, it is possible to reduce the frequency of cleaning works for the liquid immersion member 6. In addition, if the a-C film is formed on the surface of the liquid immersion member 6, even if reprecipitation of the resist component and/or the overcoat component occurs through repeated exposure processes, chemical affinity between the surface of the liquid immersion member 6 and the resist component and/or the overcoat component is low, and thus the adhesion thereof is weak and time for cleaning works for the precipitate can be reduced. Therefore, according to the present embodiment, since it is possible to reduce the frequency of and the time for the cleaning works, it is possible to shorten downtime of the liquid immersion exposure apparatus and to thereby suppress reduction in productivity.

According to the method for manufacturing the liquid immersion member of the present embodiment, it is possible to provide a liquid immersion member capable of effectively suppressing occurrence of exposure defects and suppressing reduction in productivity by reducing the frequency and time of cleaning tasks.

### Second Embodiment

Next, a second embodiment will be described. In the following description, the same reference numerals are given constituent elements which are the same as or equivalent to those in the above-described embodiment, and a description thereof will be abbreviated or omitted.

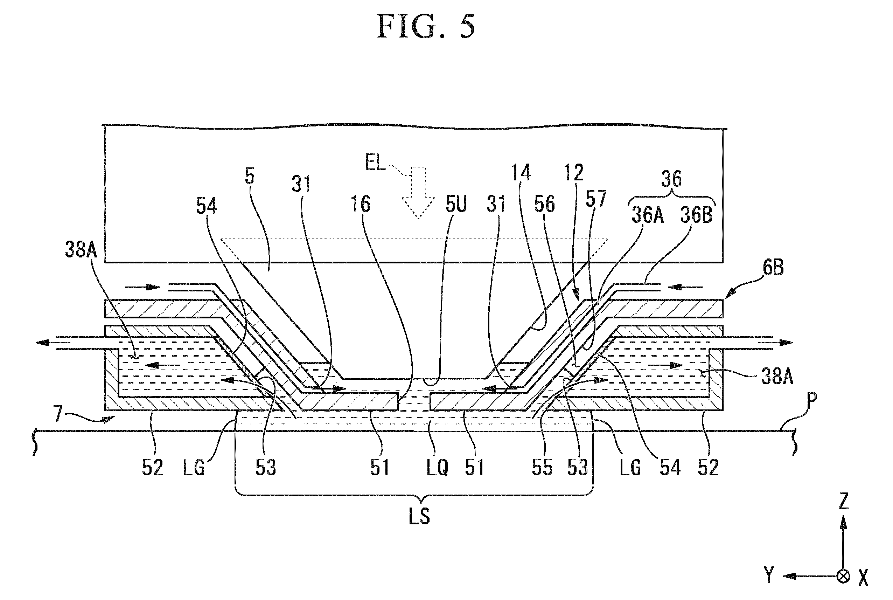

FIG. 5 is a side cross-sectional view illustrating a part of the liquid immersion member 6B according to the second embodiment. As shown in FIG. 5, the lower surface 7 of the liquid immersion member 6B includes a first land surface 51 and a second land surface 52 installed at the outer circumference of the first land surface, and the first land surface 51 and the second land surface 52 are disposed in substantially the same plane (coplanar). A flow channel 36A is formed by the side plate portion 12 installed opposite to the outer circumferential surface 14 of the longitudinal optical element 5 and an outer circumferential surface 57. The recovery hole 53 includes the surface of the porous member 54 and is disposed so as not to be opposite to the substrate P but to be opposite to the outer circumferential surface 57. In the liquid immersion member 6B of the present embodiment, the liquid LQ which flows into a gap 56 via a first opening 55 formed between the first land surface 51 and the second land surface 52 is suctioned and recovered via a porous member 54 of a recovery hole 53. In addition, the present embodiment may employ the liquid immersion member 6B with such a configuration as disclosed in Japanese Unexamined Patent Application Publication No. 2008-182241.

In the present embodiment, among the constituent members of the liquid immersion member 6B, preferred portions where the a-C film is formed may include constituent members of the regions coming into contact with the liquid LQ in the same manner as the first embodiment, and include, for example, the recovery hole 53, the porous member 54, the first land surface 51, the second land surface 52, and the outer circumferential surface 57. Among them, the a-C film is preferably formed on the second land surface 52 coming into the interface LG of the liquid LQ and the porous member 54 which is the recovery hole 53 recovering the liquid LQ. In addition, a configuration of the porous member 54 and a method of forming the a-C film on the porous member 54 are the same as those in the first embodiment.

In the present embodiment as well, since it is possible to suppress reprecipitation of the resist component and/or the overcoat component in the liquid LQ, exposure defects can be suppressed from occurring due to peeling of the precipitate and adhesion to the substrate P. In addition, since the frequency of cleaning works can be reduced by suppressing reprecipitation of the resist component and/or the overcoat component, it is possible to suppress reduction in productivity.

### Third Embodiment

Next, a third embodiment will be described. In the following description, the same reference numerals are given constituent elements which are the same as or equivalent to those in the above-described embodiment, and a description thereof will be abbreviated or omitted.

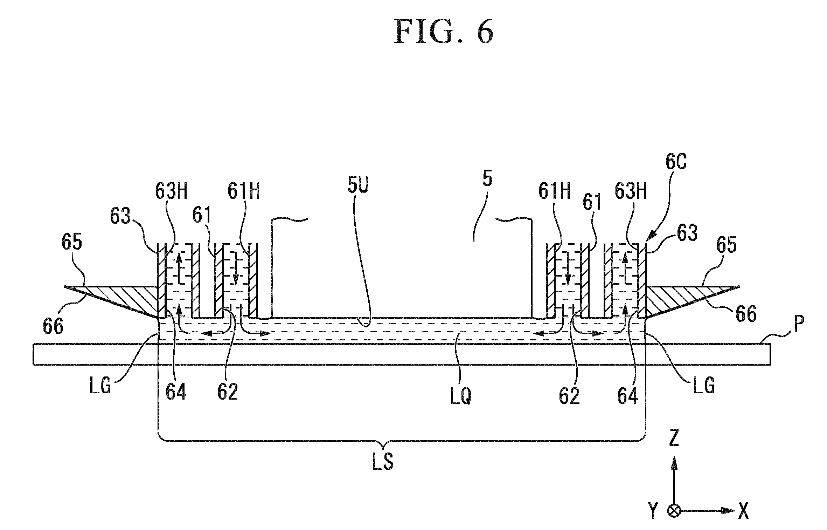

FIG. 6 is a side cross-sectional view illustrating a part of the liquid immersion member 6C according to the third embodiment. As shown in FIG. 6, in the liquid immersion member 6C, a supply flow channel 61H formed by a supply member 61 which is installed around the longitudinal optical element 5 has a supply hole 62 opposite to the substrate P. A recovery flow channel 63H which is formed at the outer circumference of the supply member 61 by a recovery member 63 has a recovery hole 64 opposite to the substrate P. A trap member 65 is installed at the outer circumference of the recovery member 63, and a trap surface 66 is a surface facing toward the substrate P side in the trap member 65 is inclined with respect to the horizontal surface as shown in FIG. 6. In the liquid immersion member 6C of the present embodiment, the liquid LQ which is supplied from the supply hole 62 to the substrate P in the nearly vertical direction to the substrate surface is supplied so as to be wet and spread between the lower surface 5U of the longitudinal optical element 5 and the substrate P. In addition, the liquid LQ of the liquid immersion space LS is sucked and recovered from the recovery hole 64 in the nearly vertical direction to the substrate surface. Further, in the present embodiment, the present embodiment may employ the liquid immersion member 6C with a configuration as disclosed in Japanese Unexamined Patent Application Publication No. 2005-109426.

In the present embodiment, among the constituent members of the liquid immersion member 6C, preferred portions where the a-C film is formed may include constituent members of the regions coming into contact with the liquid LQ in the same manner as the first embodiment, and include, any one of the supply member 63, the recovery member 62, and the trap member 65 (the trap surface 66).

In the present embodiment as well, since it is possible to suppress reprecipitation of the resist component and/or the overcoat component in the liquid LQ, exposure defects can be suppressed from occurring due to peeling of the precipitate and adhesion to the substrate P. In addition, since the frequency of cleaning tasks can be reduced by suppressing reprecipitation of the resist component and/or the overcoat component, it is possible to suppress reduction in productivity.

### Fourth Embodiment

Next, a fourth embodiment will be described. In the following description, the same reference numerals are given constituent elements which are the same as or equivalent to those in the above-described embodiment, and a description thereof will be abbreviated or omitted.

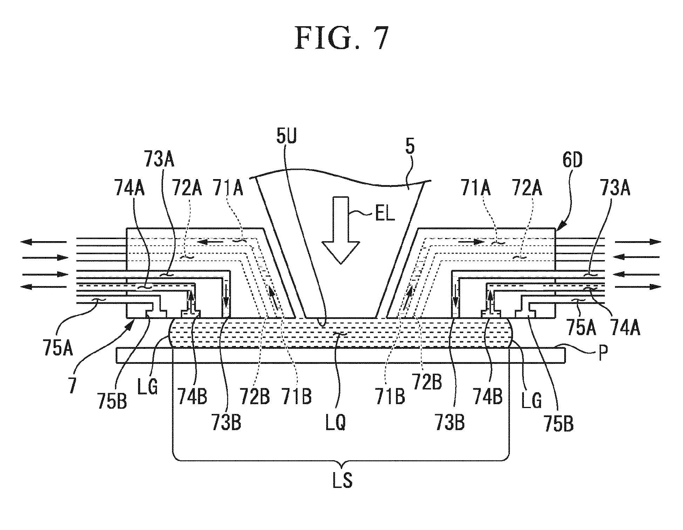

FIG. 7 is a side cross-sectional view illustrating a part of the liquid immersion member 6D according to the fourth embodiment. As shown in FIG. 7, in the liquid immersion member 6D, a pressure adjustment recovery flow channel 71A, a pressure adjustment supply flow channel 72A, a supply flow channel 73A, a recovery flow channel 74A, and an auxiliary recovery flow channel 75A are formed in this order from the inner circumferential side of the liquid immersion member 6D to the outer circumferential side thereof around the longitudinal optical element 5. In the lower surface 7 of the liquid immersion member 6D, a pressure adjustment recovery hole 71B, a pressure adjustment supply hole 72B, a supply hole 73B, a recovery hole 74B, and an auxiliary recovery hole 75B are formed in this order from the inner circumferential side of the liquid immersion member 6D to the outer circumferential side thereof around the longitudinal optical element 5 so as to be opposite to the substrate P. In the liquid immersion member 6D of the present embodiment, the liquid LQ supplied from the supply hole 73B is wet and spread on the substrate P, thereby forming the liquid immersion region LS. The liquid LQ of the liquid immersion region LS is sucked and recovered from the recovery hole 74B. In a case where the liquid LQ of the liquid immersion region LS on the substrate P is not entirely recovered by the recovery hole 74B, the liquid which has not been entirely recovered flows to outside of the recovery hole 74B but can be recovered via the auxiliary recovery hole 75B. In addition, during exposure of the substrate P, the liquid LQ of the liquid immersion space LS is recovered from the pressure adjustment recovery hole 71B or the liquid LQ is supplied from the pressure adjustment supply hole 72B to the liquid immersion space LS, thereby controlling the liquid immersion region LS so as to have desired pressure and shape.

Further, in the present embodiment, the present embodiment may employ the liquid immersion member 6D with such a configuration as disclosed in Japanese Unexamined Patent Application Publication No. 2005-233315.

In the present embodiment, among the constituent members of the liquid immersion member 6D, preferred portions where the a-C film is formed may include constituent members of the regions coming into contact with the liquid LQ in the same manner as in the first embodiment.

In the present embodiment as well, since it is possible to suppress reprecipitation of the resist component and/or the overcoat component in the liquid LQ, exposure defects can be suppressed from occurring due to peeling of the precipitate and adhesion to the substrate P. In addition, since the frequency of cleaning works can be reduced by suppressing reprecipitation of the resist component and/or the overcoat component, it is possible to suppress reduction in productivity.

In addition, although, in the respective embodiments described above, the optical path on the emission side (the upper surface side) of the longitudinal optical element 5 of the projection optical system PL is filled with the liquid LQ, a projection optical system PL may be employed in which the optical path on the incident side (object surface side) of the longitudinal optical element 5 is also filled with the liquid LQ as disclosed in, for example, Pamphlet of International Publication No. 2004/019128.

In addition, although, in the respective embodiments described above, water (pure water) is used as the liquid LQ, liquid other than water may be used. The liquid LQ is preferably liquid which is transmissive with respect to the exposure light EL, has high refractive index with respect to the exposure light EL, and is stable with respect to a film such as a sensitive material (photoresist) forming a surface of the projection optical system PL or the substrate P. For example, as the liquid LQ, fluorine liquid such as hydro fluoro ether (HFE), perfluoropolyether (PFPE), or Fomblin oil may be used. In addition, as the liquid LQ, a variety of fluids, for example, a supercritical fluid may be used.

In addition, as the above-described substrate P in each embodiment, not only a semiconductor wafer for manufacturing a semiconductor device, but also a glass substrate for display device, a ceramic wafer for thin film magnetic head, or an original plate (synthetic silica, silicon wafer) of a mask or a reticle used in an exposure apparatus is employed.

As the exposure apparatus EX, a scanning exposure apparatus (scanning stepper) of a step-and-scan type where the mask M and the substrate P are moved in synchronization with each other and a pattern of the mask M is scanned and exposed, and a projection exposure apparatus (stepper) of a step-and-repeat type where a pattern of the mask M is collectively exposed in a state where the mask M and the substrate P are stopped and the substrate P is moved step by step, may be employed.

In addition, in the exposure of the step-and-repeat type, a reduced image of a first pattern may be transferred onto the substrate P using a projection optical system in a state where the first pattern and the substrate P are nearly stopped, and then a reduced image of a second pattern may partially overlap the first pattern using the projection optical system and be collectively exposed onto the substrate P (a collective exposure apparatus of a stitch type) in a state where the second pattern and the substrate P are nearly stopped. In addition, as the stitch type exposure apparatus, an exposure apparatus of a step-and-stitch type where at least two patterns partially overlap each other and are transferred onto the substrate P, and the substrate P is sequentially moved, is employed.

In addition, as disclosed in the specification of U.S. Patent No. 6611316, the present invention may be applied to an exposure apparatus where two mask patterns are synthesized on a substrate via a projection optical system, and double exposures are performed for a single shot region on the substrate by one scanning exposure nearly at the same time. In addition, the present invention may be employed to a proximity type exposure apparatus, a mirror projection aligner, and the like.

In addition, the exposure apparatus EX may be a twin-stage type exposure apparatus including a plurality of substrate stages, as disclosed in, for example, the specification of U.S. Patent No. 6341007, the specification of U.S. Patent No. 6208407, and the specification of U.S. Patent No. 6262796. In this case, a recovery flow channel which is provided with a recovery hole at an end portion and has a capturing surface may be provided in each of a plurality of substrate stages, or may be provided in some of the substrate stages.

In addition, the exposure apparatus EX may be used in which a substrate stage holding a substrate, a reference member where a reference mark is formed, and/or a variety of photoelectric sensors are mounted therein and which includes a measurement stage which does not hold a substrate which is an exposure target, as disclosed in, for example, the specification of U.S. Patent No. 6897963, the specification of U.S. Unexamined Patent Application Publication No. 2007/0127006, or the like. Further, the present invention may be applied to an exposure apparatus including a plurality of substrate stages and a measurement stage. In this case, a recovery flow channel which is provided with a recovery hole at an end portion and includes a capturing surface may be disposed at the measurement stage.

The kind of exposure apparatus EX is not limited to an exposure apparatus for manufacturing semiconductor devices which exposes a semiconductor device pattern onto the substrate P, and the present invention may be widely applied to an exposure apparatus for manufacturing liquid crystal display devices or display devices, an exposure apparatus for manufacturing thin film magnetic heads, imaging devices (CCD), micro-machines, MEMS, DNA chips, reticles, or masks, or the like.

Further, although, in the respective embodiments described above, positional information of each stage is measured using the interferometer system using a laser interferometer, the present invention is not limited thereto and may use, for example, an encoder system which detects a scale (diffraction grating) provided at each stage.

In addition, although, in the respective embodiments described above, a light transmissive mask where a predetermined light blocking pattern (or a phase pattern or a photosensitive pattern) is formed on a light transmissive substrate is used, instead of this mask, a variable shaped mask (also called an electron mask, an active mask, or an image generator) which forms a transmissive pattern, a reflective pattern, or an emission pattern on the basis of electronic data of a pattern to be exposed, may be used, as disclosed in, for example, the specification of U.S. Patent No. 6778257. In addition, a pattern forming apparatus including a self-emission type image display element may be used instead of the variable shaped mask including a non-emission type image display element.

Although the exposure apparatus including the projection optical system PL has been described as an example in the respective embodiments described above, the present invention may be applied to an exposure apparatus which does not use the projection optical system PL and an exposure method. For example, a liquid immersion space may be formed between an optical member such as a lens and a substrate, and the substrate may be irradiated with exposure light via the optical member.

In addition, for example, as disclosed in Pamphlet of International Publication WO2001/035168, the present invention may be applied to an exposure apparatus (lithography system) where interference fringes are formed on the substrate P, and thereby a line-and-space pattern is exposed onto the substrate P.

The exposure apparatus EX of the respective embodiments described above is manufactured by assembling a variety of sub-systems including the constituent elements recited in the claims of the present application so as to maintain predetermined mechanical accuracy, electrical accuracy and optical accuracy. In order to secure these various accuracies, before and after the assembly, adjustment for achieving the optical accuracy for a variety of optical systems, adjustment for achieving the mechanical accuracy for a variety of mechanical systems, and adjustment for achieving the electrical accuracy for a variety of electrical systems are performed. An assembling process from a variety of sub-systems to the exposure apparatus includes mechanical connection, wire connection of an electric circuit between each other of a variety of sub-systems, pipe connection of a pressure circuit, and the like. Needless to say, each of the sub-systems includes an individual assembling process before the assembling process from a variety of sub-systems to the exposure apparatus. If the assembling process from a variety of sub-systems to the exposure apparatus finishes, the various accuracies for the entire exposure apparatus are secured through comprehensive adjustment. In addition, the manufacturing of the exposure apparatus is preferably performed in a clean room where temperature and cleanliness are managed.

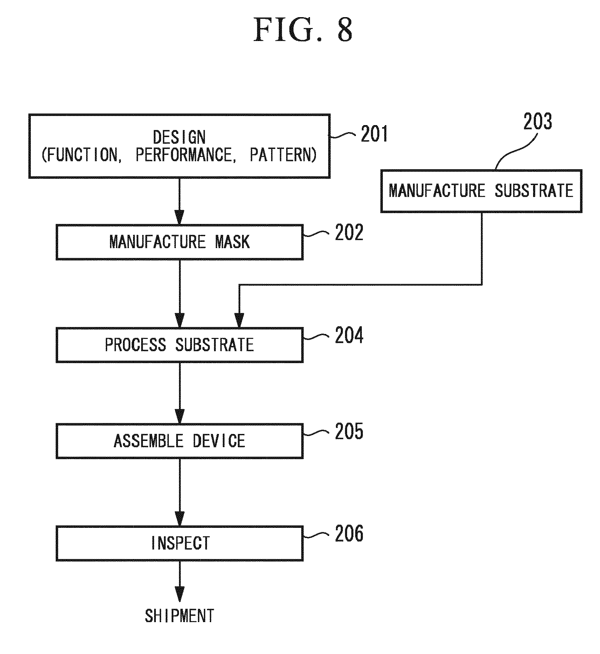

As shown in FIG. 8, a micro-device such as a semiconductor device is manufactured through a step 201 where functions and performance of the micro-device are designed, a step 202 where a mask (reticle) based on the design step is manufactured, a step 203 where a substrate which is a base material of the device is manufactured, a substrate processing step 204 including a process of exposing the substrate to exposure light from a pattern of the mask using the exposure apparatus of the above-described embodiments and a process of developing the exposed substrate, a device assembling step (including manufacturing processes such as a dicing process, a bonding process and a packaging process) 205, an inspection step 206, and the like.

In addition, the requirements of the respective embodiments described above may be appropriately combined. In addition, there are cases where some constituent elements may not be used. In addition, all the publications and the disclosures of U.S. patents regarding an exposure apparatus and the like cited in the respective embodiments described above and modified examples are incorporated herein by reference to the extent permitted by law.

### [Examples]

Hereinafter, the present invention will be described more in detail on the basis of Examples, but the present invention is not limited to the Examples.

In present Example, a tetrahedral amorphous carbon (ta-C) film was formed on a Ti plate (a porous plate made of titanium) where a plurality of through-holes were provided, thereby manufacturing the liquid immersion member related to the present embodiment.

### Manufacturing Example

The Ti plate where a plurality of through-holes were provided was cleaned by ultrasonic waves in an organic solvent, an alkali solution and an acid solution. The cleaned Ti plate was installed at the substrate holder of the film forming chamber of the FCVA film forming apparatus with the configuration as shown in FIG. 3A such that a film is formed on one surface (hereinafter, referred to as a surface A). Next, the substrate holder was inclined such that an angle of the surface A of the Ti plate became 45 degrees (φ=45 degrees in FIG. 3B) with respect to the emission direction of carbon ion beams, and further the ta-C film was formed while rotating the Ti plate in such a direction (θY direction) where the Y axis in FIG. 3B became a rotation axis with the substrate holder. In addition, the film was formed under the condition that sp³-C was 85% by adjusting a bias voltage and a pulse frequency.

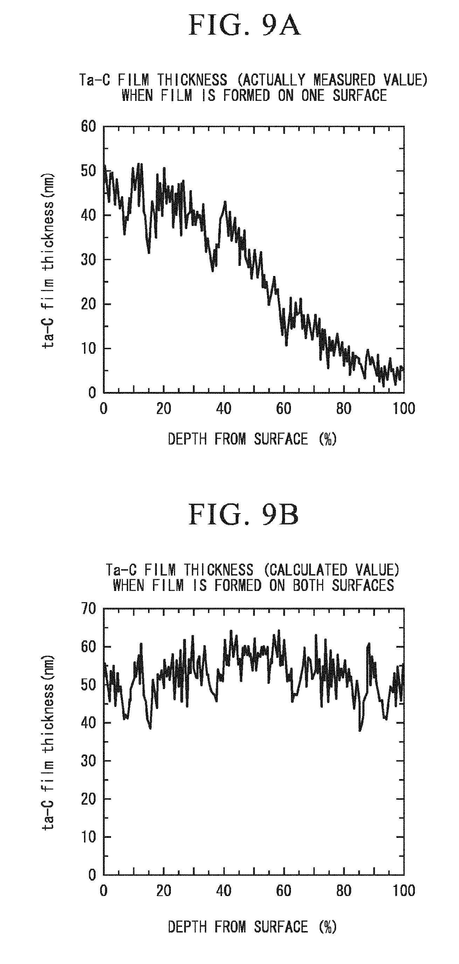

FIG. 9A shows a result where the thicknesses of the ta-C films formed on the inner wall surfaces of the through-holes of the Ti plate were measured while varying a position (depth) from the surface (surface A) after the formation of the film on the surface A was completed. In addition, measurement of the thicknesses of the ta-C films was performed by examining a carbon amount using an energy dispersive X-ray fluorescence spectrometer (EDX; made by HORIBA, Ltd., EX-250), and using a step gauge (made by KLA-Tencor Corporation, P2).

Next, the ta-C film was also formed on a rear surface (hereinafter, referred to as a surface B) of the surface A under the same condition as in the film forming method on the surface A side. FIG. 9B shows a result where the thicknesses of the ta-C films formed on the inner wall surfaces of the through-holes of the Ti plate were calculated in relation to a position (depth) from the surface (surface A) and were plotted. Further, since the film forming conditions for the surface A side and the surface B side are the same, the film thickness distribution of the ta-C films on the inner wall surfaces of the through-holes was assumed to be the same as in FIG. 9A and was calculated by adding these values to each other.

It was confirmed from the result shown in FIG. 9B that the ta-C films were formed on the inner wall surfaces of the through-holes with the uniform film thickness (about 50 µm). In addition, the film thicknesses of the ta-C films on the surface A and the surface B were about 50 µm.

Through the above processes, the liquid immersion member (porous member) where the ta-C films were formed on the surfaces (the surface A and the surface B) of the Ti plate and the inner wall surfaces of the through-holes was obtained.

### Evaluation

The manufactured liquid immersion member (hereinafter, referred to as a "Ti plate (with the ta-C film)") and a porous plate made of titanium (hereinafter, referred to as a "Ti plate (with no ta-C film)") where the ta-C film is not formed were prepared. When pure water was dropped on the surfaces of the two Ti plates and a contact angle was measured, a contact angle with the Ti plate (with the ta-C film) was about 60 degrees, and a contact angle with the Ti plate (with no ta-C film) was about 0 degrees. From this result, it is clear that the ta-C films are formed on the super-hydrophilic Ti plate, thereby expressing water repellency.

Next, 10µl of sample solution where an overcoat was added to the pure water was dropped on the surfaces of the two Ti plates and was dried.

After dried, the surface of each Ti plate was observed, and contaminating materials were formed at portions corresponding to edges of liquid droplets of the dropped sample solution. These contaminating materials were analyzed using a time-of-flight secondary ion mass spectrometry (TOF-SIMS), and it was found that the overcoat component dissolved in the pure water was precipitated due to evaporation of the pure water. In addition, the contaminating materials on the surface of the Ti plate (with the ta-C film) were precipitated only in the very narrow range as compared with the Ti plate (with no ta-C film) and thus looked like a small spot. This is because a contact angle of the surface of the Ti plate (with the ta-C film) with the pure water is about 60 degrees and expresses appropriate water repellency, and thus the sample solution is repelled, thereby suppressing extensible wetting. On the other hand, this is because the surface of the Ti plate (with no ta-C film) is super-hydrophilic, and thus the sample solution is wet and spread on the surface of the Ti plate in a wide range, thereby widening the precipitation region of the contaminating materials. From this result, it can be said that there is an effect of reducing contamination since contaminating materials due to precipitation of the overcoat component are not spread in a wide range but remain at a local region in the Ti plate (with the ta-C film) which is a liquid immersion member related to the present invention.

Next, through the above test, evaluation of ease of cleaning (cleaning test) was performed for each Ti plate where the contaminating materials were precipitated on the surface.

### Cleaning Test 1

Each Ti plate was cleaned by transmitting pure water 300 ml therethrough so as to pass through the through-holes of the Ti plate in a state where each Ti plate where the contaminating materials were precipitated was horizontally located. In addition, in order to transmit the pure water through the Ti plate, the pure water was sucked from one side of the Ti plate and was transmitted to the other side. The contamination on the cleaned Ti plate (with the ta-C film) was completely removed. On the other hand, in the cleaned Ti plate (with no ta-C film), the contamination was left at the same portion as before being cleaned.

### Cleaning Test 2

Each Ti plate where the contaminating materials were precipitated on the surface was cleaned by immersing it into pure water in a beaker for an hour. The contamination on the cleaned Ti plate (with the ta-C film) was completely removed. On the other hand, in the cleaned Ti plate (with no ta-C film), the contamination was left at the same portion as before being cleaned.

### Cleaning Test 3

Each Ti plate where the contaminating materials were precipitated on the surface was cleaned by immersing it into pure water in a beaker for an hour and then further by giving ultrasonic vibration (28 KHz, for 30 minutes). The contamination on the cleaned Ti plate (with the ta-C film) was completely removed. On the other hand, in the cleaned Ti plate (with no ta-C film), the contamination was left at the same portion as before being cleaned.

From the results of the cleaning tests 1 to 3, it is clear that, in the Ti plate (with the ta-C film) which is a liquid immersion member related to the present invention, as compared with the Ti plate (with no ta-C film), contamination is easily cleaned even if the surface is contaminated.

### Reference Signs List

2 SUBSTRATE STAGE, 5 LONGITUDINAL OPTICAL ELEMENT, 6 LIQUID IMMERSION MEMBER, 22 LIQUID RECOVERY REGION (RECOVERY SURFACE), 24 POROUS MEMBER, 24H THROUGH-HOLE (HOLE), EL EXPOSURE LIGHT, EX EXPOSURE APPARATUS, K OPTICAL PATH, LQ LIQUID, LS LIQUID IMMERSION SPACE (LIQUID IMMERSION REGION), P SUBSTRATE

## Claims

1. A liquid immersion member which holds liquid between the liquid immersion member and an object such that an optical path of exposure light applied to the object is filled with the liquid, thereby forming a liquid immersion space, comprising:
an amorphous carbon film that is formed on at least a part of a region coming into contact with the liquid.

2. The liquid immersion member according to claim 1, further comprising a liquid recovery region that is provided around the optical path of the exposure light and sucks and recovers liquid on an object facing thereto.

3. The liquid immersion member according to claim 2, wherein the amorphous carbon film is formed on at least a part of a region coming into contact with the liquid in the liquid recovery region.

4. The liquid immersion member according to claim 2 or 3, wherein the liquid recovery region includes a surface of a porous member.

5. The liquid immersion member according to claim 4, wherein the porous member includes a through-hole.

6. The liquid immersion member according to claim 4 or 5, wherein at least some of the liquid on the object is recovered via the porous member.

7. The liquid immersion member according to any one of claims 4 to 6, wherein amorphous carbon films are formed on a surface of the porous member and inner wall surfaces of a plurality of the through-holes provided at the porous member.

8. The liquid immersion member according to claim 7, wherein the surface of the porous member or at least some of the inner wall surfaces of the through-holes are lyophilic with respect to the liquid.

9. The liquid immersion member according to claim 7 or 8, wherein the surface of the porous member or at least some of the inner wall surfaces of the through-holes are liquid-repellent with respect to the liquid.

10. The liquid immersion member according to claim 9, wherein the surface of the porous member is liquid-repellent with respect to the liquid, and
wherein the inner wall surfaces of the through-holes of the porous member are lyophilic with respect to the liquid.

11. The liquid immersion member according to any one of claims 1 to 10, wherein at least some of regions where the amorphous carbon films are formed are lyophilic with respect to the liquid.

12. The liquid immersion member according to any one of claims 1 to 11, wherein the amorphous carbon film is a tetrahedral amorphous carbon film.

13. The liquid immersion member according to any one of claims 1 to 12, further comprising a member made of titanium.

14. A method for manufacturing a liquid immersion member which holds liquid between the liquid immersion member and an object such that an optical path of exposure light applied to the object is filled with the liquid, thereby forming a liquid immersion space, comprising:
forming an amorphous carbon film on at least a part of a region coming into contact with the liquid using a CVD method (Chemical Vapor Deposition method) or a PVD method (Physical Vapor Deposition method).

15. The method for manufacturing the liquid immersion member according to claim 13, wherein the liquid immersion member further includes a liquid recovery region that is provided around the optical path of the exposure light and sucks and recovers liquid on an object facing thereto, and
wherein the amorphous carbon film is formed on at least a part of a region coming into contact with the liquid in the liquid recovery region using a CVD method or a PVD method.

16. The method for manufacturing the liquid immersion member according to claim 13 or 14, wherein an FCVA (Filtered Cathodic Vacuum Arc) method is used as the PVD method.

17. The method for manufacturing the liquid immersion member according to any one of claims 13 to 15, wherein the amorphous carbon film is formed, and then at least a part of the amorphous carbon film is irradiated with ultraviolet rays such that the irradiated region is made to be lyophilic with respect to the liquid.

18. The method for manufacturing the liquid immersion member according to claim 15 or 16, wherein a tetrahedral amorphous carbon film is formed as the amorphous carbon film.

19. The method for manufacturing the liquid immersion member according to claim 17, tetrahedral amorphous carbon films are formed on a surface of the porous member disposed in the liquid recovery region and inner wall surfaces of a plurality of through-holes provided at the porous member using an FCVA method.

20. The method for manufacturing the liquid immersion member according to any one of claims 17 to 18, wherein a tetrahedral amorphous carbon film is formed, and then at least a part of the tetrahedral amorphous carbon film is irradiated with ultraviolet rays such that the irradiated region is made to be lyophilic with respect to the liquid.

21. The method for manufacturing the liquid immersion member according to claim 18 or 19, further comprising:
forming a tetrahedral amorphous carbon film;
irradiating the surface of the porous member and the inner wall surfaces of the through-holes with ultraviolet rays such that the irradiated regions are made to be lyophilic with respect to the liquid; and
forming the tetrahedral amorphous carbon film on the surface of the porous member using an FCVA method,
wherein the surface of the porous member is liquid-repellent with respect to the liquid, and the inner wall surfaces of the through-holes of the porous member are lyophilic with respect to the liquid.

22. The method for manufacturing the liquid immersion member according to any one of claims 14 to 21, wherein the liquid immersion member includes a member made of titanium.

23. An exposure apparatus which exposes a substrate to exposure light via liquid, comprising:
the liquid immersion member according to any one of claims 1 to 12.

24. The exposure apparatus according to claim 23, wherein the liquid immersion member is provided at a part of a liquid recovery mechanism which recovers the liquid.

25. The exposure apparatus according to claim 23 or 24, wherein the liquid immersion member includes a member made of titanium.

26. A device manufacturing method comprising:
a step of exposing a substrate using the exposure apparatus according to any one of claims 23 to 25; and
a step of developing the exposed substrate.
